# EUROPÄISCHE PATENTSCHRIFT

(11) **EP 0 503 525 B1**
(45) Veröffentlichungstag und Bekanntmachung des Hinweises auf die Patenterteilung: **24.04.1996**
(21) Anmeldenummer: 92103982.2
(22) Anmeldetag: 09.03.1992
(51) Int. Cl.: H01B 12/00, H01L 39/24

(54) **Verfahren zur Herstellung von supraleitenden Drähten**
Method for producing superconducting wires
Procédé pour fabriquer des fils supraconducteur

(30) Priorität: 15.03.1991 DE 4108445
(43) Veröffentlichungstag der Anmeldung: 16.09.1992
(73) Patentinhaber: ABB PATENT GmbH, D-68309 Mannheim (DE)
(72) Erfinder: Knaak, Wolfgang, Dr., W-6900 Heidelberg (DE); Jahnke, Bernd, Dr., W-6903 Neckargemünd (DE)
(74) Vertreter: Rupprecht, Klaus, Dipl.-Ing.

(56) Entgegenhaltungen:
- EP-A- 0 311 337
- EP-A- 0 357 779

## Beschreibung

Die Erfindung bezieht sich auf ein Verfahren zur Herstellung von Hochtemperatursupraleiterdrähten gemäß dem Oberbegriff des Patentanspruches 1.

Solche Drähte kommen dort zum Einsatz, wo elektrische Leiter erforderlich sind, die in der Lage sind, Ströme mit mehreren 1000 A/cm zu tragen.

Aus dem Stand der Technik sind bereits Hochtemperatursupraleiterdrähte bekannt, für deren Herstellung Metallhülsen mit einem supraleitenden Material gefüllt werden. Eine Vielzahl solcher Metallhülsen wird dann in einer weiteren Metallhülle angeordnet, welche die Metallhülsen vollständig umschließt. Anschließend wird die Metallhülle so weit gezogen, daß ihr Querschnitt auf eine definierte Größe verkleinert wird. Anschließend wird diese Metallhülle gewalzt, so daß hierdurch ein Band gebildet wird, und die in ihr angeordneten Hülsen zu flachen Filamenten umgeformt werden. Diese bekannten Bänder sind für die Wechselstromanwendung bzw. Gleichstromanwendung mit schnellen Stromänderungen nicht geeignet, da diese Geometrie zu großen Wechselstromverlusten führt. Solche Drähte sind z.B. aus der EP-A-0 357 779 bekannt.

Der Erfindung liegt die Aufgabe zugrunde, ein Verfahren aufzuzeigen, mit dem Hochtemperatursupraleiterdrähte mit niedrigen Verlusten und hohen Stromdichten hergestellt werden können.

Diese Aufgabe wird erfindungsgemäß durch die Merkmale des Patentanspruches 1 gelöst.

Zur Herstellung dieser Hochtemperatursupraleiterdrähte werden Bänder verwendet, die im Innern flache supraleitende Filamente aufweisen. Diese Bänder werden zu einem Stapel aufeinandergesetzt. Vorzugsweise wird zwischen jeweils zwei aufeinanderfolgenden Bändern eine hochohmige Zwischenchicht aus Nickelkupfer oder weichem Stahl angeordnet. Anschließend wird der Stapel in einen zylinderförmigen, aus Metall gefertigten Mantel gesteckt, der die Bänder vollständig umschließt. Daraufhin wird der Metallmantel umgeformt, so daß sich sein Durchmesser auf einen definierten Wert verkleinert. Anschließend wird der metallische Mantel verdrillt. Es schließt sich eine Wärmebehandlung bei einer Temperatur zwischen 800 und 850°C an. Gleichzeitig wird ein isostatischer Druck von 100 MPa auf den Draht ausgeübt. Hierdurch wird das supraleitende Material verdichtet. Gleichzeitig führt die bereits in den Bändern erzielte Ausbildung von flachen Filamenten zu einer starken Textur des Supraleiters, was eine hohe Stromdichte innerhalb des Drahtes ermöglicht.

Weitere erfindungswesentliche Merkmale sind in den Unteransprüchen gekennzeichnet.

Das Verfahren wird nachfolgend anhand von schematischen Zeichnungen erläutert.

Es zeigen:
- Fig. 1: die einzelnen Verfahrensschritte zur Bildung eines Hochtemperatursupraleiterdrahtes,
- Fig. 2: den Aufbau eines für die Herstellung des Drahtes verwendeten Stapels,
- Fig. 3: eine Variante des erfindungsgemäßen Verfahrens.

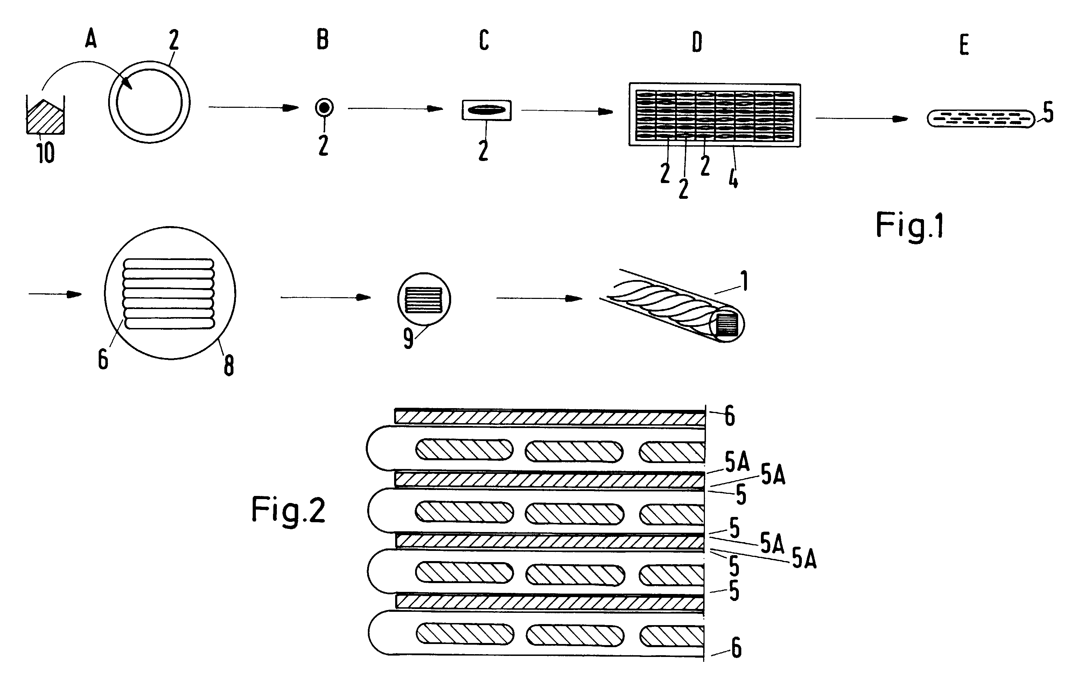

Wie anhand von Fig. 1, Position A, zu sehen ist, werden zur Herstellung des erfindungsgemäßen Hochtemperatursupraleiterdrahtes 1 runde Hülsen 2 aus Metall mit einem Werkstoff 10 gefüllt, der bereits supraleitende Eigenschaften aufweist oder diese bei einer anschließenden Wärmebehandlung erhält. Die Hülsen 2 weisen einen Durchmesser von 0,5 bis 13 cm auf. Sie sind ca. 20 bis - 100 cm lang und aus Silber und/oder einer Nickelkupferverbindung hergestellt. Selbstverständlich können die Hülsen 2 auch aus anderen, die erforderlichen Eigenschaften aufweisenden Materialien gefertigt werden. Die Hülsen 2 werden bei dem hier beschriebenen Ausführungsbeispiel mit einem keramischen supraleitendem Werkstoff in Form eines Pulvers oder einer Schmelze gefüllt. Vorzugsweise wird ein keramischer supraleitender Werkstoff verwendet, der als eine Komponente Wismut enthält. Besonders geeignet ist Wismutkuprat mit oder ohne Bleizusätzen, das die Struktur Bi₂Sr₂Ca₂Cu₃O₁₀ oder Bi₂Sr₂Ca₁Cu₂O₈ aufweist. Die mit dem supraleitenden Material voll ausgefüllten Hülsen 2 werden anschließend so gezogen, daß sich ihr ursprünglicher Durchmesser auf einen Wert von 0,1 bis 1 cm reduziert, wie in Position B dargestellt. Gleichzeitig wird der Querschnitt zu einem Rechteck umgeformt, wie Position C zeigt. Anschließend werden eine Vielzahl dieser rechteckigen Hülsen 3, vorzugsweise 20 bis 150 Stück, in eine metallische Hülle 4 mit rechteckigem Querschnitt gesteckt, dargestellt in Position D . Diese Hülle 4 ist aus einer Nickelkupferlegierung gefertigt. Für ihre Herstellung können auch andere Metallegierungen verwendet werden, die den Erfordernissen im Betrieb des hochtemperatursupraleitenden Drahtes genügen. Die Länge der Hülle 4 ist so bemessen, daß die Hülsen 3 vollständig umschlossen werden. Ihre Abmessung wird so gewählt, daß die gewünschte Anzahl von Hülsen 3 problemlos in ihr untergebracht werden kann. Anschließend wird die Hülle 4 so umgeformt, daß sich ihre ursprüngliche Höhe auf 0,05 bis 0,5 cm und ihre Breite auf 0,5 bis 10 cm reduziert wird, so daß Bänder 5 gemäß Position E gebildet werden. Aus diesen Bändern 5 wird nun, wie Fig. 2 zeigt, ein Stapel 6 durch Aufeinandersetzen der Bänder 5 gebildet. Zur Verringerung der Wechselstromverluste kann zwischen jeweils zwei aufeinanderfolgenden Bändern 5 eine Zwischenschicht 5A angeordnet werden. Hierbei handelt es sich um ein Band aus einem hochohmigem Metall, vorzugsweise aus Nickelkupfer oder weichem Stahl mit einer Dicke von 0,1 bis 2 mm.
Ein so gebildeter Stapel 6 wird in einen zylindrischen Mantel 8 aus Metall geschoben, der den Stapel 6 vollständig umgibt, gemäß Position F. Der Durchmesser des Mantels 8 beträgt 1 bis 15 cm. Nach dem Einsetzen des Stapels 6 in den zylindrischen Mantel 8 wird der Mantel 8 umgeformt, wobei sein Durchmesser auf einen Wert von 1 bis 2 mm reduziert wird, gemäß Position G. Der so gebildete Draht 9 wird mit einer vorgegebenen Steigungshöhe von etwa 5 bis 10 mm verdrillt. Anschließend wird der Draht 9 einer Wärmebehandlung unterzogen. Die Wärmebehandlung erfolgt in einem Temperaturbereich zwischen 800 und 850°C. Hierdurch kommt es zu einer Oxidation der Oberflächen der Metallbänder 5A, so daß über diese keine Wirbelströme mehr fließen können. Diese Wärmebehandlung wird vorzugsweise bei einem hohen isostatischen Druck von 100 MPa durchgeführt, um die Dichte des supraleitenden Materials zu erhöhen. Hierdurch werden die Bänder 5 und die in ihnen befindlichen flächigen Filamente 2 dauerhaft in einer definierten räumlichen Ausrichtung angeordnet. Die Textur des Supraleiters bewirkt eine hohe Stromdichte, die bei dem fertiggestellten Draht 1 300 A/mm beträgt.

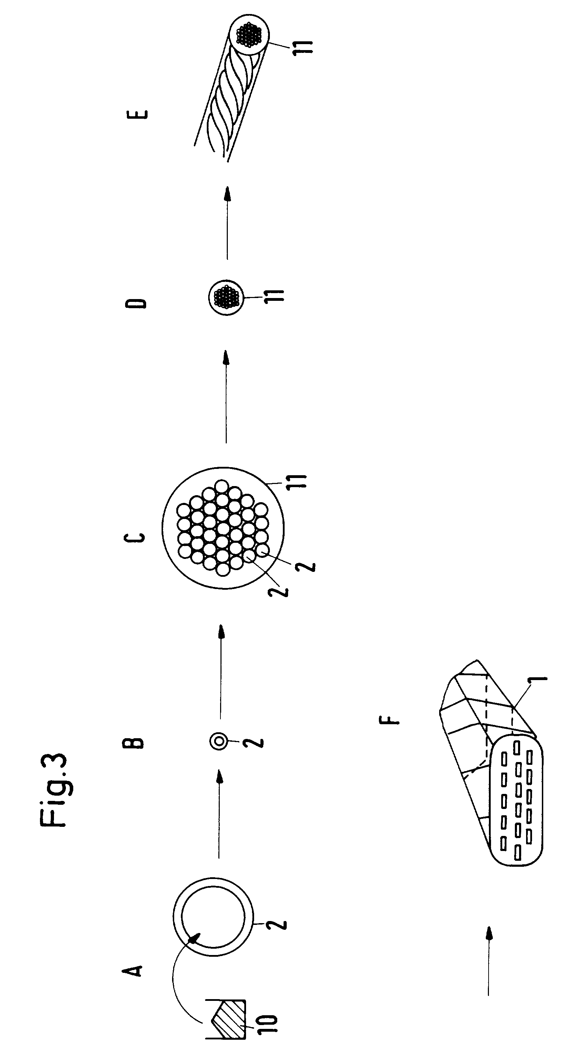

In Fig. 3 ist eine Variante des erfindungsgemäßen Verfahrens dargestellt. Hierfür werden Hülsen 2, wie bei dem in Fig. 1 erläuterten Verfahren mit einem der obenerwähnten supraleitenden Materialien 10 gefüllt (Position A). Die Hülsen 2 haben die gleichen Durchmesser und Längen, wie die in Fig. 1 dargestellten und in der zugehörigen Beschreibung erläuterten Hülsen 2. Anschließend werden die Hülsen 2 soweit gezogen, daß ihr Durchmesser jetzt nur noch 0,1 bis 1 cm beträgt (Position B). Nun werden bis zu 100 dieser Hülsen 2 innerhalb einer metallischen Hülle 11 angeordnet (Position C). Die Hülle 11 hat einen Durchmesser von 1 bis 15 cm. Ihre Länge ist so bemessen, daß die Hülsen 2 von ihr vollständig umschlossen werden. Die Hülle 11 wird dann soweit gezogen, daß ihr Durchmesser nur noch 1 bis 4 mm beträgt (Position D). Anschließend wird sie mit einer Steigungshöhe verdrillt, die bis zum 5-fachen seines Durchmessers betragen kann (Position E). Anschließend wird die Hülle 11 so umgeformt, daß ein Band 1 entsteht, das eine Dicke von etwa 0,5 bis 1 mm und eine Breite von 1 bis 4 mm aufweist (Position F). Die in der Hülle 11 angeordneten Hülsen 2 werden durch das Walzen zu flächigen Filamenten 2 umgeformt, und so angeordnet, daß sie innerhalb des Bandes 1 eine definierte räumliche Ausrichtung erfahren. Das Band 1 wird jetzt noch einer Wärmebehandlung unterzogen, wie sie in der Beschreibung zu Fig. 1 erläutert ist. Die Wärmebehandlung erfolgt vorzugsweise bei einem isostatischen Druck mit den in der Beschreibung zu Fig. 1 angegebenen Werten.

## Patentansprüche

1. Verfahren zur Herstellung eines hochtemperatursupraleitenden Drahts (1) aus Filamenten, die aus mit einem supraleitenden Werkstoff gefüllten Hülsen (2) bestehen, deren Durchmesser reduziert und deren Querschnitt rechteckig geformt ist, dadurch gekennzeichnet, daß der Durchmesser der Filamente (2) auf 0,1 bis 2 mm reduziert wird, und 20 bis 150 rechteckige Filamente (2) in einer Hülle (4) aus einer Nickelkupferlegierung angeordnet werden, daß die Hülle zur Bildung eines Bandes (5) so umgeformt wird, daß ihre ursprüngliche Höhe auf 0,05 bis 0,5 cm und ihre ursprüngliche Breite auf 0,5 bis 10 cm reduziert wird, daß wenigstens zwei Bänder (5) zu einem Stapel (6) aufeinander gesetzt werden, und zwischen jeweils zwei aufeinander gesetzten Bändern (5) eine als Band ausgebildete Zwischenschicht (5A) aus einem hochohmigen Metall angeordnet wird, daß die zu einem Stapel aufgesetzten Bänder (5) in einem zylinderförmigen Mantel (8) angeordnet werden, der anschließend in seiner Längsrichtung um mehr als einen Faktor 10 gedehnt wird, daß der so gebildete Draht (9) mit einer Steigungshöhe bis zum 5-fachen seines Durchmessers verdrillt wird, und daß der Draht (9) daraufhin einer Wärmebehandlung bei einer Temperatur von 800°C bis 850°C unterzogen und ein isostatischer Druck von 100 MPa zur Erhöhung der Dichte des supraleitenden Materials auf den Draht (9) ausgeübt wird.

2. Verfahren zur Herstellung eines hochtemperatursupraleitenden Drahts (1) aus Filamenten, die aus mit einem supraleitenden Werkstoff gefüllten Hülsen (2) bestehen, dadurch gekennzeichnet, daß der Durchmesser der Hülsen (2) auf 0,1 bis 1cm reduziert wird, daß bis zu 100 Hülsen in einer Hülle (11) aus einer Nickelkupferlegierung angeordnet werden, deren Durchmesser anschließend auf einen Wert zwischen 1 bis 4 mm reduziert und mit einer Steigungshöhe, die dem 5-fachen oder mehr ihres Durchmessers entspricht, verdrillt und im Anschluß daran zu einem den hochtemperatursupraleitenden Draht (1) bildenden Band (5) mit einer Dicke von 0,5 bis 1 mm und einer Breite zwischen 1 und 4 cm gewalzt und anschließend einer Wärmebehandlung bei einer Temperatur zwischen 800°C und 850°C unter der Einwirkung eines isostatischen Drucks von 100 MPa unterzogen wird.

3. Verfahren nach einem der Ansprüche 1 oder 2, dadurch gekennzeichnet, daß die Hülsen (2) aus Silber und/oder einer Nickelkupferlegierung gefertigt mit einem supraleitenden Material in Form von Wismitkuprat (Bi₂Sr₂Ca₂Cu₃O₁₀ oder Bi₂Sr₂Ca₂Cu₂O₈) mit oder ohne Bleizusatz gefüllt werden.

## Claims

1. Method of producing a high-temperature superconducting wire (1) composed of filaments which comprise sheaths (2) which are filled with a superconducting material and whose diameter is reduced and whose cross-section is of rectangular shape, characterized in that the diameter of the filaments (2) is reduced to 0.1 to 2 mm and 20 to 150 rectangular filaments (2) are fitted in an envelope (4) made of a nickel/copper alloy, in that the envelope is reshaped in order to form a strip (5) in such a way that the original height of the envelope is reduced to 0.05 to 0.5 cm and its original width to 0.5 to 10 cm, in that at least two strips (5) are mounted to form a stack (6) and an interlayer (5A) made of a high-resistance metal and formed as a strip is fitted between every two strips (5) mounted one on the other, in that the strips (5) which are mounted to form a stack are fitted in a cylindrical jacket (8) which is then extended in its longitudinal direction by more than a factor of 10, in that the wire (9) which is formed in this way is twisted with a pitch of up to 5 times its diameter, and in that the wire (9) is subsequently subjected to a heat treatment at a temperature between 800 and 850°C and an isostatic pressure of 100 MPa is exerted on the wire (9) in order to increase the density of the superconducting material.

2. Method of producing a high-temperature superconducting wire (1) composed of filaments which comprise sheaths (2) filled with a superconducting material, characterized in that the diameter of the sheaths (2) is reduced to 0.1 to 1 cm, in that up to 100 sheaths are fitted in an envelope (11) made of a nickel/copper alloy whose diameter is then reduced to a value between 1 to 4 mm, and twisted with a pitch which corresponds to 5 or more times its diameter, is then rolled to form a strip (5) which forms the high-temperature superconducting wire (1) with a thickness of 0.5 to 1 mm and a width between 1 and 4 cm and is subsequently subjected to a heat treatment at a temperature between 800°C and 850°C while being exposed to an isostatic pressure of 100 MPa.

3. Method according to one of Claims 1 or 2, characterized in that the sheaths (2) are produced from silver and/or a nickel/copper alloy and are filled with a superconducting material in the form of bismuth cuprate (Bi₂Sr₂Ca₂Cu₃O₁₀ or Bi₂Sr₂Ca₂Cu₂O₈) with or without lead added.

## Revendications

1. Procédé pour fabriquer un fil (1) supraconducteur à haute température à partir de filaments constitué de gaines (2) remplies d'un matériau supraconducteur, gaines dont le diamètre est réduit et dont la section est conformée en rectangle, **caractérisé** par le fait que le diamètre des filaments (2) est réduit à une valeur de 0,1 à 2 mm, que 20 à 150 filaments rectangulaires (2) sont disposés dans une chemise (4) en un alliage cupro-nickel, que la chemise est déformée, en vue de la formation d'une bande (5), de telle manière que sa hauteur initiale soit réduite à une valeur de 0,05 à 0,5 cm et sa largeur initiale à une valeur de 0,5 à 10 cm, qu'au moins deux bandes (5) sont superposées en un empilage (6), qu'une couche intermédiaire (5A) en forme de bande, en un métal à résistance ohmique élevée, est disposée respectivement entre deux bandes (5) superposées, que les bandes (5) superposées en un empilage sont disposées dans une enveloppe cylindrique (8) qui est ensuite allongée dans sa direction longitudinale de plus de dix fois, que le fil (9) ainsi formé est torsadé avec un pas qui est jusqu'à cinq fois supérieur à son diamètre, que le fil (9) est ensuite soumis à un traitement thermique à une température de 800°C à 850°C et qu'une pression isostatique de 100 MPa est exercée sur le fil (9) en vue de l'augmentation de la densité du matériau supraconducteur.

2. Procédé pour fabriquer un fil (1) supraconducteur à haute température à partir de filaments constitués de gaines (2) remplies d'un matériau supraconducteur, **caractérisé** par le fait que le diamètre des gaines (2) est réduit à une valeur de 0,1 à 1 cm, que jusqu'à 100 gaines sont disposées dans une chemise (11) en un alliage cupro-nickel, dont le diamètre est ensuite réduit à une valeur comprise entre 1 et 4 mm, qui est torsadée avec un pas correspondant à cinq fois son diamètre ou plus et est ensuite laminée sous la forme d'une bande (5) qui constitue le fil (1) supraconducteur à haute température et présente une épaisseur de 0,5 à 1 mm et une largeur de 1 à 4 cm, et qui est ensuite soumise à un traitement thermique à une température comprise entre 800°C et 850°C sous l'action d'une pression isostatique de 100 MPa.

3. Procédé suivant l'une des revendications 1 ou 2, **caractérisé** par le fait que les gaines (2) fabriquées en argent et/ou un alliage cupro-nickel sont remplies d'un matériau supraconducteur sous la forme d'un cuprate de bismuth (Bi₂Sr₂Ca₂Cu₃O₁₀ ou Bi₂Sr₂Ca₂Cu₂O₈) avec ou sans addition de plomb.
